Europäisches Patentamt

(19) European Patent Office

Office européen des brevets

(11) **EP 0 911 969 B1**

(12) **FASCICULE DE BREVET EUROPEEN**

(45) Date de publication et mention
de la délivrance du brevet:
**25.02.2004 Bulletin 2004/09**

(51) Int Cl.⁷: **H03J 5/24**, H03F 3/191,
H03F 3/72

(21) Numéro de dépôt: **98402604.7**

(22) Date de dépôt: **20.10.1998**

(54) **Circuit amplificateur à double gain**

Verstärkerschaltung mit Doppelverstärkung

Amplifier circuit with dual gain

(84) Etats contractants désignés:
**DE FR GB IT**

(30) Priorité: **22.10.1997 FR 9713232**

(43) Date de publication de la demande:
**28.04.1999 Bulletin 1999/17**

(73) Titulaire: **STMicroelectronics S.A.**
**92120 Montrouge (FR)**

(72) Inventeur: **Belot, Didier**
**38140 Rives (FR)**

(74) Mandataire: **Poulin, Gérard et al**
**BREVALEX**
**3, rue du Docteur Lancereaux**
**75008 Paris (FR)**

(56) Documents cités:
**EP-A- 0 475 118**     **DE-A- 2 829 164**
**US-A- 3 333 200**     **US-A- 3 611 001**
**US-A- 4 520 324**     **US-A- 5 313 207**

**Description**

Domaine technique et art antérieur

L'invention concerne la réalisation d'un dispositif amplificateur à gain commutable, en particulier pour les applications radiofréquences (RF), dans un domaine de fréquences supérieur à 500 MHz, par exemple dans le domaine du gigahertz.

On connaît déjà des réalisations de circuits amplificateurs à bas bruit et à gain commutable.

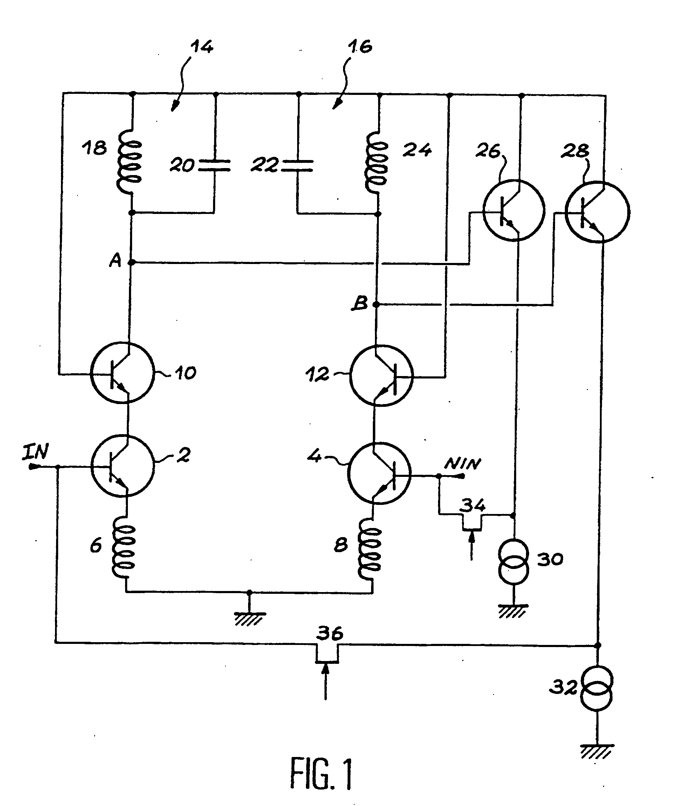

La première réalisation est illustrée sur la figure 1. L'amplificateur représenté sur cette figure comporte deux amplificateurs d'entrée 2, 4. L'émetteur de chacun de ces deux amplificateurs est relié à une inductance 6, 8 de compensation de la capacité d'entrée (capacité base-émetteur) du transistor bipolaire correspondant.

Chacun des deux amplificateurs d'entrée est associé à un amplificateur 10, 12, de manière à réaliser un montage cascode. Le collecteur de chacun de ces deuxièmes amplificateurs 10, 12 voit un circuit de charge, ou circuit bouchon, 14, 16 qui est en fait un circuit LC comportant d'une part une capacité 20, 22 et d'autre part une inductance 18, 24, montées en parallèle.

Deux transistors de sortie 26, 28 sont montés en émetteurs-suiveurs et reliés chacun à une source de courant 30, 32. Leur base est reliée, respectivement, aux points A et B. Ces transistors fournissent donc un signal image du signal dans le circuit LC de charge correspondant.

Afin de réaliser une commutation entre un état à gain élevé et un état à bas gain, ce circuit comporte des moyens 34, 36 permettant de court-circuiter l'étage de gain : ainsi, l'entrée de chacun des amplificateurs 2, 4 est connecté à l'émetteur de chacun des amplificateurs de sortie 26, 28. Ceci a en particulier pour conséquence une modification de l'impédance d'entrée. Par ailleurs, il y a toujours le risque, lors de la commutation, de la création d'une rotation de phase entre les signaux d'entrée IN de l'amplificateur 2 et NIN de l'amplificateur 4. Une telle rotation de phase peut entraîner une oscillation du dispositif, détruisant ainsi l'effet amplificateur : le dispositif fonctionne alors comme un oscillateur, et non plus comme un amplificateur, avec ou sans gain.

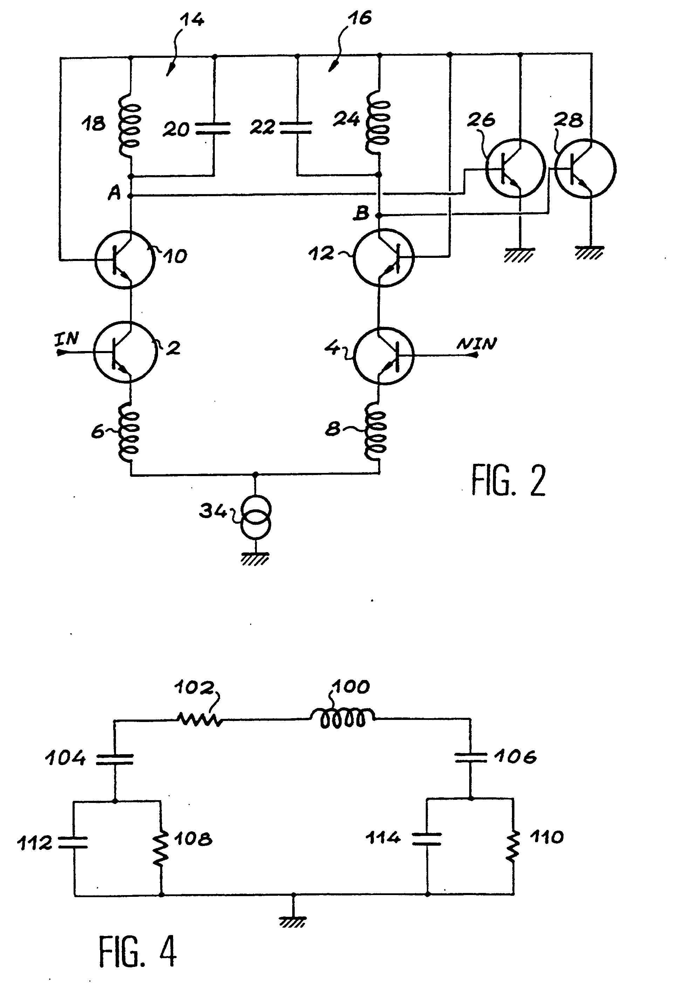

L'autre solution connue va être décrite en liaison avec la figure 2. Des références numériques identiques à celles de la figure 1 y désignent des mêmes éléments. Les inductances 6, 8 de compensation sont reliées à une source de courant 34 qui détermine le courant de l'étage d'entrée. Une variation du courant de l'étage d'entrée entraîne une variation de la capacité de chacun des transistors d'entrée 2, 4 ; en effet, la capacité de ces transistors est liée au positionnement du point de polarisation dudit transistor. De cette variation de la capacité de chaque transistor d'entrée résulte une variation de l'impédance d'entrée du système. Cependant, toute variation de l'impédance d'entrée nuit à l'adaptation du système, et cette deuxième solution n'est, de ce point de vue, pas meilleure que la première.

Il se pose donc le problème de réaliser un dispositif amplificateur à double gain, ou même à gain multiple, dont la structure permette, quel que soit le gain sélectionné, de ne pas changer les caractéristiques d'entrée de l'amplificateur.

Exposé de l'invention

L'invention a pour objet un dispositif amplificateur à double gain comportant :

- un premier et un second amplificateurs d'entrée,
- un troisième et un quatrième amplificateurs réalisant avec les premier et second amplificateurs d'entrée, un premier et un second montages cascodes,
- un premier et un deuxième circuits LC, montés en parallèle et sur le troisième amplificateur, ainsi qu'un troisième et quatrième circuits LC, montés en parallèle et sur le quatrième amplificateur, les premier et troisième circuits LC ayant chacun un premier facteur de qualité, les deuxième et quatrième circuits LC ayant chacun un second .facteur de qualité,
- des moyens pour commuter le dispositif amplificateur d'un premier état, dans lequel seuls les premier et troisième circuits LC sont passants à un second état dans lequel, à la fois, les quatre circuits LC sont dans un état passant.

On dispose alors, pour chacun des deux amplificateurs d'entrée, de deux circuits de facteur de qualité différents, qui permettent de modifier la valeur du gain, à l'aide des moyens de commutation. Grâce aux troisième et quatrième amplificateurs réalisant, avec les premier et second amplificateurs d'entrée, des montages cascodes, l'impédance d'entrée du dispositif n'est pas modifiée, ce qui permet de conserver une adaptation d'impédance parfaite d'un très bon coefficient de réflexion.

Les seconds facteurs de qualité (des deuxième et quatrième circuits LC) sont par exemple plus faibles que les premiers facteurs de qualité (des premier et troisième circuits LC).

L'inductance de chacun des deuxième et quatrième circuits LC peut être intégrée sur un substrat en silicium. Une inductance intégrée sur silicium ne peut être séparée de ses propres éléments parasites, dus au substrat silicium lui-même et aux matériaux métalliques de l'inductance, qui réduisent le facteur de qualité de l'inductance. Ceci a pour effet de limiter le gain possible obtenu sur un circuit parallèle LC, à une fréquence donnée. On réalise ainsi une inductance présentant un facteur de qualité médiocre. Cette inductance, associée à une capacité C, forme un circuit LC de facteur de qualité également médiocre. On peut donc utiliser une telle inductance pour réaliser par exemple les deuxième et quatrième circuits LC, qui présentent alors un faible facteur de qualité.

Les troisième et quatrième amplificateurs peuvent être réalisés en technologie bipolaire ou bien en technologie MOS.

Quant aux moyens pour réaliser une commutation du dispositif entre un premier et un second états, ils peuvent comporter un premier et un second transistors MOS.

Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :

- La figure 1 représente un premier dispositif à double gain, selon l'art antérieur.
- La figure 2 représente un autre dispositif connu de l'art antérieur, également à double gain.
- La figure 3 représente un mode de réalisation d'un amplificateur à double gain selon l'invention.
- La figure 4 représente un modèle d'une inductance intégrée sur silicium.
- La figure 5 représente des courbes de gain d'un dispositif selon l'invention, avec commutateurs fermés.
- La figure 6 représente des courbes de gain d'un dispositif selon l'invention, avec commutateurs ouverts.
- La figure 7 représente le coefficient de réflexion en entrée d'un dispositif selon l'invention.
- La figure 8 représente les parties réelle et imaginaire de l'impédance d'entrée d'un dispositif selon l'invention.

Description détaillée de modes de réalisation de l'invention

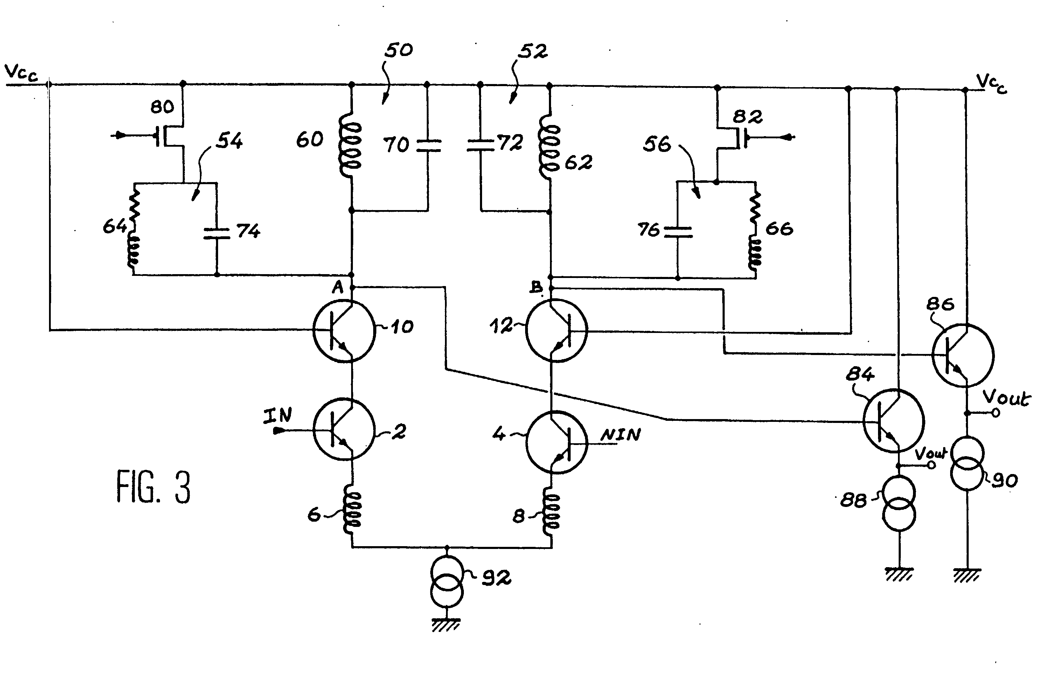

Un dispositif amplificateur à double gain, conforme à l'invention, est illustré en figure 3.

Comme sur les figures 1 et 2, les références 2 et 4 désignent des amplificateurs d'entrée, chacun étant associé à une inductance 6, 8 de compensation (de valeur d'inductance $L_6$, $L_8$) ayant la même fonction que celle déjà exposée ci-dessus en liaison avec les figures 1 et 2. Des amplificateurs 10 et 12 réalisent, avec les amplificateurs 2 et 4, des montages cascodes. Tous ces amplificateurs peuvent être réalisés soit en technologie bipolaire, soit en technologie MOS.

Au premier montage cascode constitué des amplificateurs 2 et 10 sont associés deux circuits LC 50, 54 constitués respectivement d'une inductance 60 (de valeur $L_2$), 64 (de valeur $L_1$) montées chacune en parallèle d'une capacité 70 (de valeur $C_2$), 74 (de valeur $C_1$). Les deux circuits 50, 54 sont montés eux-mêmes en parallèle. En outre, un commutateur 80 est associé au circuit 54. Suivant l'état passant ou ouvert de ce commutateur 80, l'amplificateur 10 voit le seul circuit de charge 50 ou bien les deux circuits de charge 50, 54 en parallèle.

De même, au deuxième montage cascode 4, 12 sont associés deux circuits 52, 56, chaque circuit étant un circuit LC constitué d'une inductance 62 (de valeur $L_2$), 66 (de valeur $L_1$) montée en parallèle à une capacité 72 (de valeur $C_2$), 76 (de valeur $C_1$). Au circuit 56 est associé un moyen de commutation 82. Selon l'état passant, ou fermé, de ce commutateur 82, l'amplificateur 12 voit, en tant que circuit de charge, uniquement le circuit 52, ou bien les deux circuits 52, 56 disposés en parallèle.

Le circuit comporte en outre deux transistors de sortie 84, 86 dont les bases sont reliées aux points A et B. Ces transistors fournissent un signal image du signal dans le circuit de charge correspondant. Chacun de ces deux transistors de sortie est associé à une source de courant 88, 90 et est monté en émetteur-suiveur. Les transistors de sortie et les circuits de charge sont reliés à un rail d'alimentation 51 en tension $V_{cc}$.

Une source de courant 92 permet d'assurer dans les émetteurs des transistors d'entrée 2, 4 un courant constant. On peut également, pour imposer un tel courant constant, imposer une polarisation constante sur l'entrée des transistors 2, 4.

Les moyens de commutation 80, 82 sont de préférence réalisés avec des transistors MOS, montés en interrupteurs.

Le circuit ci-dessus a été décrit avec, associés à chacun des transistors 10, 12 deux circuits LC dont l'un peut être commuté, ou pas, en parallèle avec l'autre. Les caractéristiques de ces circuits sont choisies de manière à ce qu'ils présentent des facteurs de qualité différents l'un de l'autre. Par exemple, si le circuit LC 54 présente un facteur de qualité médiocre, tandis que le circuit 50 présente un facteur de qualité élevé, la mise en parallèle des deux circuits résulte en une variation du gain de l'amplificateur.

De préférence, on choisit $L_1$, $L_2$, $C_1$, $C_2$ de telle sorte que :

$$L_1C_1=L_2C_2,$$

ce qui assure le maintien de la fréquence d'oscillation des circuits de charge quel que soit l'état du dispositif, c'est-à-dire quel que soit l'état de commutation des commutateurs 80, 82. A cette fin, on peut prendre : $L_1 \ll L_2$ et $C_1 \gg C_2$.

Un moyen commode de réaliser des circuits LC de facteurs de qualité différents consiste à réaliser des inductances $L_1$, $L_2$ de facteurs de qualité différents. On cherche donc à réaliser, par exemple : une inductance $L_2$ de valeur élevée et de facteur de qualité élevé,

et une inductance $L_1$ de valeur faible et de facteur de qualité faible.

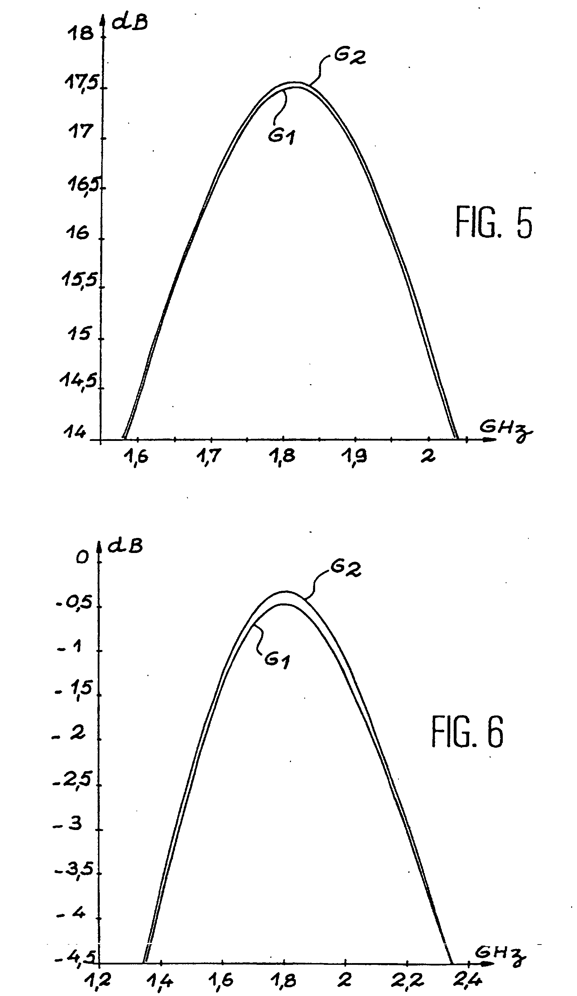

Ce résultat peut être obtenu en réalisant des inductances intégrées sur silicium. En effet, une inductance intégrée sur silicium ne peut être séparée de ses éléments parasites qui réduisent le facteur de qualité de cette dernière : il en résulte une limitation du gain possible obtenu sur un circuit de charge LC à une fréquence donnée. La figure 4 représente un modèle d'une inductance 100 réalisée sur silicium, avec ses éléments parasites : résistances parasites 102, 108, 110 et capacités parasites 104, 106, 112, 114. La modification des caractéristiques de l'inductance 100 entraîne une modification des valeurs des résistances et des capacités parasites. Par exemple, si l'inductance présente une surface de contact plus large avec le substrat en silicium, ces éléments parasites associés (résistances, capacités) seront d'autant plus importants. Le facteur de qualité de l'inductance, pour une pulsation $\omega$ donnée, résulte, au premier ordre, de la formule :

$$Q=L\omega/R,$$

où R désigne la valeur de la résistance parasite 102.

Il est alors possible de réaliser une inductance présentant un facteur de qualité médiocre, ladite inductance pouvant ensuite être associée à une capacité 76, 74 pour constituer l'un des circuits 54, 56 : le facteur de qualité de ces circuits sera moyen, ou médiocre (par exemple : Q<2,5), et en tout cas différent de celui des circuits 50, 52 (par exemple : Q>4) réalisés selon une autre technologie. Les circuits 50, 52 sont par exemple réalisés en technologie ASGA ou par montage sur circuit imprimé. On a alors des substrats isolants, il n'y a donc pas d'élément parasite suffisant. On peut donc obtenir Q>10.

Un procédé pour réaliser une inductance sur un substrat en silicium est par ailleurs décrit dans l'article de J. Craninckx et al., intitulé "A 1,8 GHz low-phase-noise CMOS VCO using optimized hollow spiral inductors" paru dans IEEE Journal of solid-State Circuits, vol. 32, n° 5, 1997.

Cet article décrit ainsi l'effet parasite du substrat sur l'inductance et montre comment peut être réalisée une inductance. L'article de Y. Koutsoyannopoulos et al. Intitulé "A Generic CAD Model for arbitrarily shaped and multi-layer integrated inductors on silicon substrates", Proceedings of the ESSCIRC 97 Conference, p. 320-323, décrit les phénomènes parasites sur une inductance et tente de les modéliser.

Selon un exemple, un dispositif amplificateur selon l'invention a été réalisé, avec les caractéristiques suivantes :

- $C_1$=2,5 pF,
- $C_2$=0,8 pF,
- $L_1$=0,817 nH,

- $L_2$= 5, 02 nH,
- $L_6$=$L_8$=0,258 nH,
- les transistors 2, 4, 10, 12, 84, 86 sont des transistors npn référencés N16C.

La figure 5 représente la courbe de gain G du circuit ($G_1$=$V_{NOUT}/V_{NIN}$, $G_2$=$V_{OUT}/V_{IN}$) en fonction de la fréquence lorsque celle-ci varie de 1,55 à 2,05 GHz, et lorsque les commutateurs 80, 82 sont à l'état passant : on obtient un gain G à peu près égal à 17,55 dB $\pm$ 0,024 dB pour $\omega$=1,8GHz. La bande passante à -3dB est de 410 MHz. Le facteur de qualité du circuit, dans cet état, est donc sensiblement égal à : $Q_{ON}\approx1800/410\approx4,4$.

La figure 6 montre également l'évolution du gain ($G_1$=$V_{NOUT}/V_{NIN}$ ; $G_2$=$V_{OUT}/V_{IN}$) en fonction de la fréquence, lorsque celle-ci varie de 1,35 à 2,4 GHz, les deux commutateurs 80 et 82 étant ouverts. Le gain est à peu près égal à -0,4dB $\pm$ 0,075dB et la bande passante à -3dB est d'environ 838MHz. Il en résulte un facteur de qualité $Q\approx1800/838\approx2,15$. Le passage de l'état passant à l'état ouvert des commutateurs fait donc basculer le facteur de qualité du circuit d'une valeur de 4,4 à une valeur de 2,15.

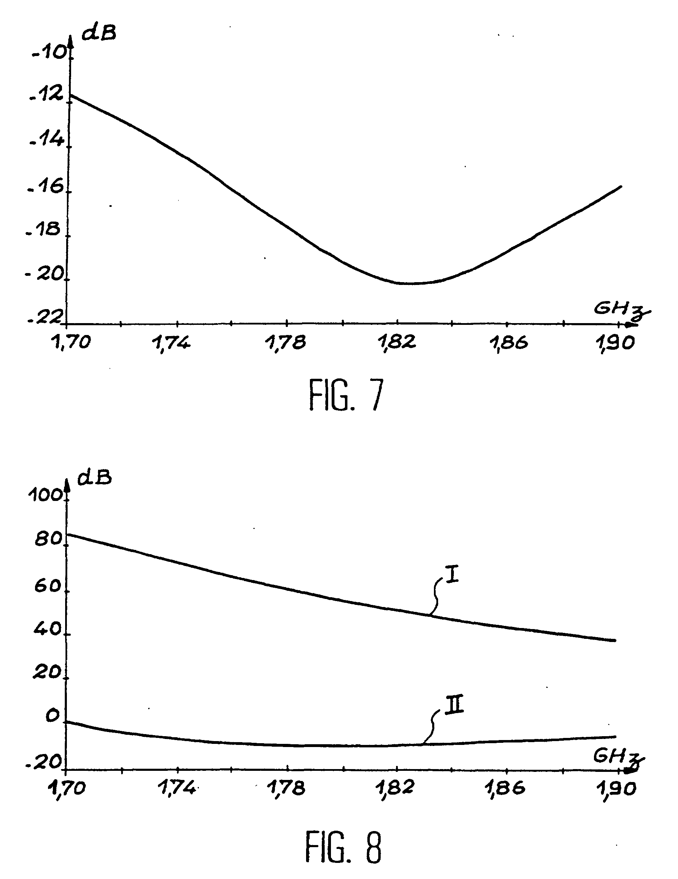

La figure 7 représente, en décibels, le coefficient de réflexion en entrée du dispositif, lorsque la fréquence varie de 1,7 à 1,9 GHz. On constate que, sur toute cette gamme de fréquences, le coefficient de réflexion est très faible et ne varie que très peu, que les commutateurs 80, 82 soient à l'état passant ou ouvert (la courbe est la même dans les deux cas).

La figure 8 représente l'impédance d'entrée du dispositif ou, plus exactement, la partie réelle (courbe I), et la partie imaginaire (courbe II) de l'impédance d'entrée. On constate que la partie imaginaire de l'impédance d'entrée reste à peu près égale à 0 sur tout le domaine de fréquences 1,7-1,9 GHz, seule la partie réelle de l'impédance ayant une valeur significative.

Ces résultats montrent bien qu'une commutation efficace est obtenue, qui permet de passer d'un gain de 17,5 dB à un gain de -0,4dB, sans variation de l'impédance d'entrée et sans modification du coefficient de réflexion. Comme déjà expliqué ci-dessus, on peut monter plusieurs circuits LC en parallèle à chaque circuit 50, 52 et obtenir une commutation entre plusieurs états, une valeur de gain étant associée à chaque état. Par exemple, on peut monter deux circuits LC en parallèle à chacun des circuits 50, 52, un commutateur étant associé à chacun de ces circuits parallèles. On peut donc passer alors, par exemple, d'une valeur de gain de 17,5 dB à une valeur de 10 dB ou à une valeur de -0,5 dB.

## Revendications

1. Dispositif amplificateur à double gain, comportant :

　　- un premier et un second amplificateurs d'entrée (2,4),

- un troisième et un quatrième amplificateurs (10, 12) réalisant avec les premier et second amplificateurs d'entrée, un premier et un second montages cascodes,

- un premier et un deuxième circuits LC (50, 54), montés en parallèle et sur le troisième amplificateur (10), ainsi qu'au moins un troisième et quatrième circuits LC (52, 56), montés en parallèle et sur le quatrième amplificateur (12), les premier et troisième circuits LC (50, 52) ayant chacun un premier facteur de qualité, les deuxième et quatrième circuits LC (54, 56) ayant chacun un second facteur de qualité,

- des moyens (80, 82) pour commuter le dispositif amplificateur d'un premier état, dans lequel seuls les premier et troisième circuits LC (50, 52) sont passants à un second état dans lequel, à la fois, les quatre circuits LC (50, 52, 54, 56) sont dans un état passant.

2. Dispositif amplificateur selon la revendication 1, l'inductance de chacun des deuxième et quatrième circuits LC (54, 56) étant intégrée sur un substrat en silicium.

3. Dispositif amplificateur selon l'une des revendications 1 ou 2, les troisième et quatrième amplificateurs (10, 12) étant réalisés en technologie bipolaire.

4. Dispositif amplificateur selon l'une des revendications 1 ou 2, les troisième et quatrième amplificateurs (10, 12) étant réalisés en technologie MOS.

5. Dispositif amplificateur selon l'une des revendications 1 à 4, les inductances des premier et troisième circuits LC (50, 52) ayant un facteur de qualité élevé, tandis que les inductances des deuxième et troisième circuits LC (54, 56) ont un facteur de qualité faible.

6. Dispositif amplificateur selon l'une des revendications 1 à 4, les inductances des premier et troisième circuits LC (50, 52) ayant un facteur de qualité faible, tandis que les inductances des deuxième et troisième circuits LC (54, 56) ont un facteur de qualité élevé.

7. Dispositif amplificateur selon l'une des revendications 1 à 6, les moyens (80, 82) pour commuter le dispositif entre un premier et un second états comportant un premier et un second transistors MOS.

**Patentansprüche**

1. Verstärkervorrichtung mit doppelter Verstärkung, mit:

- einem ersten und einem zweiten Eingangsverstärker (2,4),

- einem dritten und vierten Verstärker (10,12), die mit dem ersten bzw. zweiten Eingangsverstärker eine erste und eine zweite Kaskadenschaltung bilden,

- einer ersten und zweiten LC-Schaltung (50,54), die parallel zueinander und auf den dritten Verstärker (10) geschaltet sind, sowie mindestens einer dritten und vierten LC-Schaltung (52,56), die parallel zueinander und auf den vierten Verstärker (12) geschaltet sind, wobei die erste und dritte LC-Schaltung (50,52) jeweils einen ersten Gütefaktor und die zweite und vierte LC-Schaltung (54,56) jeweils einen zweiten Gütefaktor aufweisen,

- einem Mittel (80,82) zum Umschalten der Verstärkervorrichtung von einem ersten Zustand, in dem nur die erste und dritte LC-Schaltung (50,52) durchlässig sind, zu einem zweiten Zustand, in dem sich die vier LC-Schaltungen (50,52,54,56) in einem durchlässigen Zustand befinden.

2. Verstärkervorrichtung nach Anspruch 1, wobei die Induktanz jeder der zweiten und vierten LC-Schaltungen (54,56) auf einem Siliziumträger integriert ist.

3. Verstärkervorrichtung nach einem der Ansprüche 1 oder 2, wobei der dritte und vierte Verstärker (10,12) in bipolarer Technologie gefertigt ist.

4. Verstärkervorrichtung nach einem der Ansprüche 1 oder 2, wobei der dritte und vierte Verstärker (10,12) in MOS-Technik gefertigt ist.

5. Verstärkervorrichtung nach einem der Ansprüche 1 bis 4, wobei die Induktanzen der ersten und dritten LC-Schaltung (50,52) einen hohen Gütefaktor aufweisen, während die Induktanzen der zweiten und vierten LC-Schaltungen (54,56) einen niedrigen Gütefaktor aufweisen.

6. Verstärkervorrichtung nach einem der Ansprüche 1 bis 4, wobei die Induktanzen der ersten und dritten LC-Schaltung (50,52) einen niedrigen Gütefaktor aufweisen, während die Induktanzen der zweiten und dritten LC-Schaltung (54,56) einen hohen Gütefaktor aufweisen.

7. Verstärkervorrichtung nach einem der Ansprüche 1 bis 6, wobei die Mittel (80,82) zum Umschalten der Vorrichtung zwischen einem ersten und einem zweiten Zustand einen ersten und zweiten MOS-Transistor umfassen.

**Claims**

1. Dual gain amplifier apparatus that comprises:

   - a first and a second input amplifier (2, 4),
   - a third and a fourth amplifier (10, 12) that, with the first and second input amplifiers, constitute a first and second cascoded circuit,
   - a first and second LC circuit (50, 54) connected in parallel with one another and to the third amplifier (10), together with at least one third and fourth LC circuit (52, 56) connected in parallel with one another and to the fourth amplifier (12), the first and third LC circuits (50, 52) each having a first quality factor and the second and fourth LC circuits (54, 56) each having a second quality factor,
   - means (80, 82) for switching the amplifier apparatus from a first state in which only the first and third LC circuits (50, 52) conduct to a second state in which all four LC circuits (50, 52, 54, 56) are conducting.

2. Amplifier apparatus of claim 1 wherein the inductor of each of the second and fourth LC circuits (54, 56) is mounted on a silicon substrate.

3. Amplifier apparatus of claim 1 or 2 wherein the third and fourth amplifiers (10, 12) are constructed using bipolar technology.

4. Amplifier apparatus of claim 1 or 2 wherein the third and fourth amplifiers (10, 12) are constructed using MOS technology.

5. Amplifier apparatus of any of claims 1 to 4 wherein the inductors of the first and third LC circuits (50, 52) have a high quality factor while the inductors of the second and third LC circuits (54, 56) have a low quality factor.

6. Amplifier apparatus of any of claims 1 to 4 wherein the inductors of the first and third LC circuits (50, 52) have a low quality factor while the inductors of the second and third LC circuits (54, 56) have a high quality factor.

7. Amplifier apparatus of any of claims 1 to 6 wherein the means (80, 82) for switching the apparatus between a first and second state comprise a first and a second MOS transistor.

FIG. 1

FIG. 2

FIG. 4

FIG. 3

EP 0 911 969 B1

FIG. 5

FIG. 6

FIG. 7

FIG. 8